# EUROPÄISCHE PATENTSCHRIFT

(11) **EP 0 805 920 B1**
(45) Veröffentlichungstag und Bekanntmachung des Hinweises auf die Patenterteilung: **30.09.1998**
(21) Anmeldenummer: 95942025.8
(22) Anmeldetag: 21.12.1995
(51) Int. Cl.: F02P 7/03, H03K 3/57

(54) **ZÜNDANLAGE FÜR BRENNKRAFTMASCHINEN**
IGNITION SYSTEM FOR INTERNAL COMBUSTION ENGINES
SYSTEME D'ALLUMAGE POUR MOTEURS A COMBUSTION INTERNE

(30) Priorität: 26.01.1995 DE 19502304
(43) Veröffentlichungstag der Anmeldung: 12.11.1997
(73) Patentinhaber: ROBERT BOSCH GMBH, 70442 Stuttgart (DE)
(72) Erfinder: VOGEL, Manfred, D-71254 Ditzingen (DE); HERDEN, Werner, D-70839 Gerlingen (DE); KONRAD, Johann, D-71732 Tamm (DE)
(86) Internationale Anmeldenummer: DE9501825
(87) Internationale Veröffentlichungsnummer: WO9623139

(56) Entgegenhaltungen:
- US-A- 4 881 512

## Beschreibung

### Stand der Technik

Die Erfindung betrifft eine Zündanlage für Brennkraftmaschinen mit einem Hochspannungsschalter. Aus der EP 0 377 619 ist bereits eine Schaltungsanordnung bekannt, die mit einem Hochspannungsschalter die Verteilung der Zündspannung realisiert. Damit kommt die Zündverteileranordnung ohne bewegliche Teile aus und man spricht von einer ruhenden Hochspannungsverteilung. Hierbei wird für jede anzusteuernde Zündkerze zwischen dem hochspannungsseitigen Ende der Sekundärwicklung einer Zündspule und der Zündkerze ein Hochspannungsschalter angeordnet. Als Hochspannungsschalter werden beispielsweise Hochspannungskippdioden, wie sie aus der DE-OS 40 32 131 bekannt sind, verwendet. Die Hochspannungskippdiode besteht aus einer Vielzahl von in Reihe geschalteten Kippdioden, wobei die einzelnen Kippdiodenchips in einer Kaskadenschaltung übereinandergestapelt und anschließend an ihrem Umfang mit einem lichtdurchlässigen Isolator überzogen sind. Mit einer solchen Hochspannungskippdiode können sehr exakt hohe Spannungen geschaltet werden. Beim Stand der Technik ist es üblich, die Hochspannungskippdiode durch Bestrahlung der pn-Übergänge mit optischer Energie zu schalten. Durch die Bestrahlung mit Licht werden in den Kippdioden Ladungsträger freigesetzt, wodurch die Kippspannung herabgesetzt wird. Der Hochspannungskippdiode ist eine Leuchtdiode zugeordnet, die vom Steuergerät entsprechend der Zündfolge angesteuert wird, so daß dann die Hochspannung gezielt an die jeweilige Zündkerze durchgeschaltet wird.

### Vorteile der Erfindung

Die erfindungsgemäße Anordnung mit den Merkmalen des Hauptanspruchs hat gegenüber dem Stand der Technik den Vorteil, daß keine aufwendige Anordnung einer Leuchtdiode bzw. eines Lichtübertragungselementes von der Leuchtdiode zu den pn-Übergängen der Hochspannungskippdiode notwendig ist. Damit ist der Aufbau der Zündanlage wesentlich kostengünstiger und einfacher zu realisieren.

Durch die in den Unteransprüchen aufgeführten Maßnahmen sind vorteilhafte Weiterbildungen und Verbesserungen der im Hauptanspruch angegebenen Zündanlage möglich. Besonders vorteilhaft ist, daß durch einen Ansteuerimpuls eines Tyristors, welcher mit der Hochspannungskippdiode in Reihe liegt ein Konditionierungsstrom fließen kann, ohne daß opto-elektronische Bauelemente notwendig sind. Ein weiterer Vorteil ergibt sich durch die Teilung der Hochspannungskippdiode in einen ersten Teil, welcher aus einzelnen Kippdiodenchips mit langer Ladungsträgerspeicherzeit besteht und einen zweiten Teil, welcher Kippdiodenchips mit einer kurzen Ladungsträgerspeicherzeit enthält. Damit bleibt nach dem Abschalten des Konditionierungsstrom in dem Teil der HochspannungsKippdiode mit den Chips mit langer Ladungsträgerspeicherzeit die Kippspannung während des Hochspannungsimpulses herabgesetzt, so daß der Kippdiodeneffekt durch das "Überkopf"-Zünden des zweiten Teils der Hochspannungskippdiode erhalten bleibt.

### Zeichnung

Ausführungsbeispiele der Erfindung sind in der Zeichnung dargestellt und in der nachfolgenden Beschreibung näher erläutert. Es zeigen Figur 1 ein erstes Ausführungsbeispiel der Erfindung, Figur 2 ein zweites Ausführungsbeispiel der Erfindung, Figur 3 ein drittes Ausführungsbeispiel, Figur 4 den Spannungsverlauf in einer Zündspule und Figur 5 den Querschnitt durch einen einzelnen Kippdiodenchip.

### Beschreibung der Ausführungsbeispiele

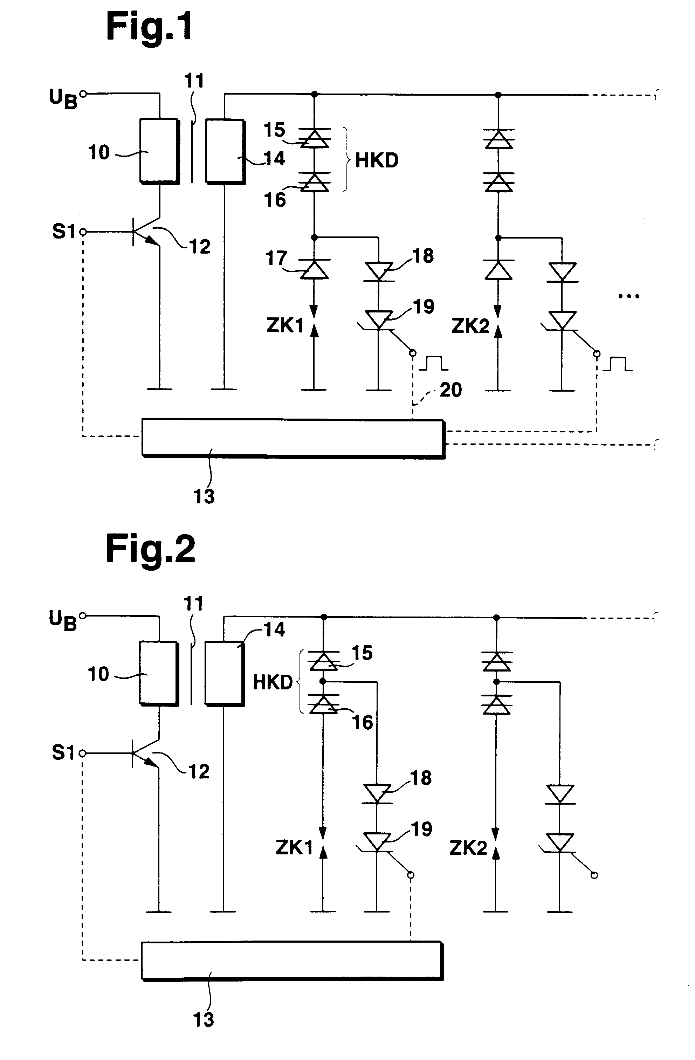

Figur 1 zeigt den Prinzipaufbau einer Zündanlage gemäß einem ersten Ausführungsbeispiel der Erfindung. Die Primärwicklung 10 einer Zündspule 11 ist mit der Versorgungsspannung U_{B} beispielsweise mit der nicht dargestellten Batterie der Brennkraftmaschine verbunden und andererseits über einen Schalttransistor 12 mit Masse verbunden ist. Der Schalttransistor 12 ist über eine Steuerklemme S1 mit einer Steuereinheit 13 verbunden. Der hochspannungsseitige Anschluß der Sekundärspule 14 ist mit den Zündkerzen ZK1 und ZK2 verbunden, wobei die Zündkerzen untereinander parallelgeschaltet sind. In der Figur 1 sind der einfachheithalber nur die Zündkerzen ZK1 und ZK2 gezeigt, jedoch können hier entsprechend der Zylinderzahl der jeweiligen Brennkraftmaschine auch mehr Zündkerzen angeschlossen sein. Im weiteren soll nur ein einzelner Hochspannungszweig erläutert werden, da der Aufbau und die Funktion in jedem Hochspannungszweig gleich ist. Zwischen dem hochspannungsseitigen Ende der Sekundärspule 14 und der Zündkerze ZK1 ist eine Hochspannungskippdiode HKD, die sich aus einem ersten Teil 15 und einem zweiten Teil 16 zusammensetzt, angeordnet. Die Hochspannungkippdiode HKD ist in Sperrichtung geschaltet. Die der Zündkerzen zugewandte Anode der Hochspannungskippdiode HKD ist über eine entgegengesetzt geschaltete Diode 17 mit der Zündkerze ZK1 verbunden. Die Diode 17 ist eine Einschaltfunkenunterdrückungsdiode. Parallel zu der Reihenschaltung aus Diode 17 und Zündkerze ZK1 und in Reihe mit der Hochspannungskippdiode HKD ist eine weitere Hochspannungsdiode 18 geschaltet und über einen steuerbaren Schalter 19, welcher beispielsweise ein Thyristor, Transistor, Photohalbleiter oder Optokoppler sein kann, mit Masse verbunden ist. In dieser Figur ist der steuerbare Schalter ein Thyristor. Der Steuereingang des Schalters hier das Gate des Thyristors 19 ist über eine Wirkverbindung 20, welche in der Figur 1 gestrichelt dargestellt ist, mit der Steuereinheit 13 verbunden.

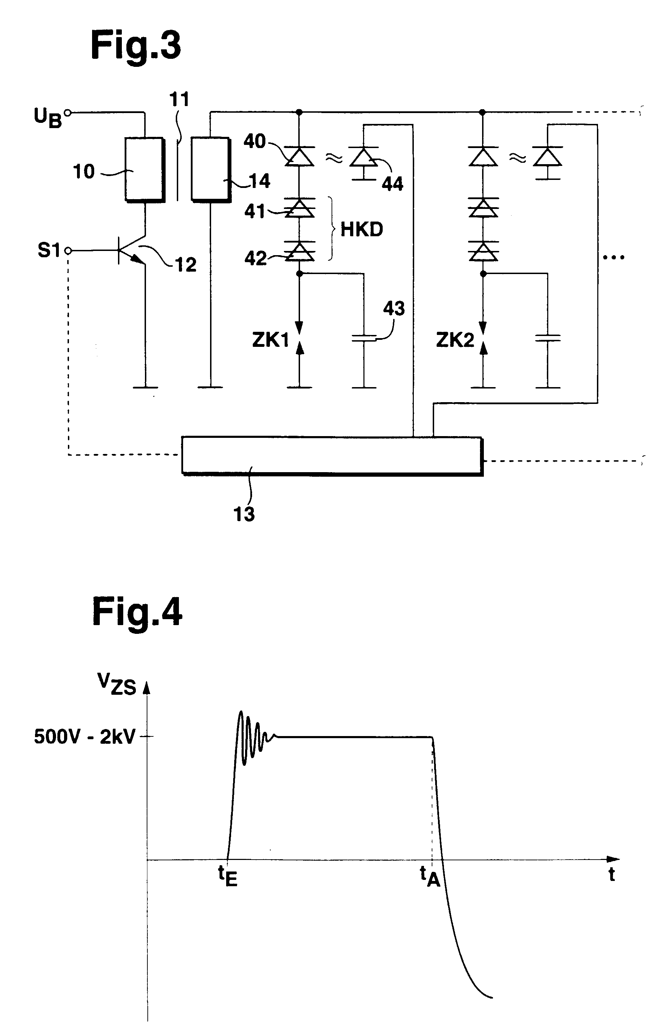

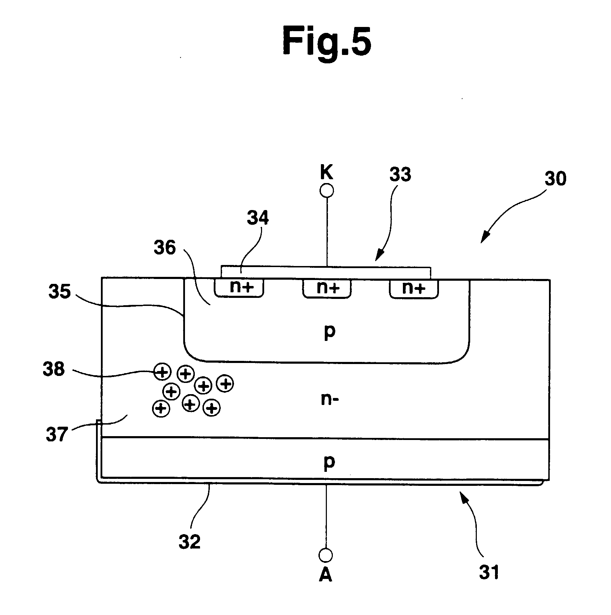

Die Funktion der Figur 1 soll im folgenden unter Zuhilfenahme der Figuren 4 und 5 erläutert werden. Die Steuereinheit 13 berechnet aufgrund von erfaßten Parametern, die von nicht dargestellten Sensoren ermittelt werden, die entsprechenden Steuergrößen. So wird beispielsweise Schließzeit und Zündzeitpunkt berechnet und aufgrund der berechneten Größen ein entsprechendes Steuersignal an den Steuereingang S1 des Schalttransistors 12 gegeben. Während der Schließzeit und damit des Ladevorganges in der Zündspule ist der Schalttransistor 12 leitend gesteuert, so daß ein Strom durch die Primärwicklung 10 der Zündspule 11 fließt. Die Zündspule 11 wird also aufgeladen. Ein entsprechender Spannungsverlauf in der Sekundärwicklung der Zündspule ist der Figur 4 zu entnehmen. Hier ist der Sekundärspannungsverlauf an der Zündspule über der Zeit schematisch dargestellt. Der Zeitpunkt t_{E} ist der Einschaltzeitpunkt für den Zündpulenstrom und somit der Schließzeitbeginn. Mit Beginn der Schließzeit steigt die Spannung auf einen Wert von ca. 0,5 bis 2kV, wobei hier ein positiver Spannungsimpuls vorliegt. Während des Ladevorganges in dem Zeitraum von t_{E} bis t_{A} liegt somit sekundärseitig am Hochspannungszweig und damit an der Hochspannungskippdiode HKD eine positive Spannung an. Für diese positive Spannung ist die Hochspannungskippdiode in Rückwärts- oder auch Durchlaßrichtung gepolt, jedoch wird ein Stromfluß in Richtung Zündkerze durch die Diode 17, welche nun in Sperrrichtung liegt, verhindert. Die Hochspannungskippdiode HKD ist derart designed, daß sie in die Rückwärtsrichtung leitend ist oder nur eine sehr geringe Sperrspannung aufweist. Auch über den Parallelzweig zur Reihenschaltung aus Diode 17 und Zündkerze ZK1 kann kein Strom fließen, wenn der Thyristor 19 sperrt, wie das ohne Ansteuerimpuls der Fall ist. Nach dem Ausschalten des Spulenladestromes zum Zeitpunkt t_{A} wird auf der Sekundärseite eine Hochspannung induziert, die jedoch gegenüber der Spannung während der Schließzeit entgegengesetzte nun negative Polarität hat. Die Hochspannungskippdiode ist eine 40 kV sperrende Hochspannungskippdiode, die sich aus einem ersten Teil 15 und einem zweiten Teil 16, wovon jeder Teil jeweils etwa 20 kV sperrt, zusammensetzt.

Bei der erfindungsgemäßen Anordnung soll nun der Tyristor 19 kurz vor dem Ende der Schließzeit einen Ansteuersingal vom Steuergerät 13 über die Wirkverbindung 20 erhalten. Durch dieses Ansteuersignal an das Gate des Tyristors 19 wird ein Stromfluß durch die Hochspannungskippdiode HKD über die Hochspannungskippdiode 18 und den Thyristor 19 möglich. Dabei wird das an und für sich sperrende Gebiet der Hochspannungskippdiode mit Ladungsträgern überschwemmt und es fließt der sogenannte Konditionierungsstrom. Die Zeit für den Konditionierungsstrom liegt typischerweise zwischen 5_{µs} und 100_{µs}, da in dieser Zeit genug Ladungsträger freigesetzt werden. Es ist günstig den Konditionierungsstrom unmittelbar vor dem Ende der Schließzeit zu bewirken. Wird nun eine Hochspannungskippdiode mit einer langen Ladungsträgerspeicherzeit gewählt, so bleiben die Ladungsträger in der Hochspannungdkippdiode vorübergehend erhalten. Bei dem anschließenden unmittelbar darauffolgendem Ausschalten des Spulenladestromes zum Zeitpunkt t_{A} steigt die Sekundärspannung sprungartig an, wobei sie nun im Gegensatz zum Ladevorgang negative Polarität aufweist. Aufgrund der im sperrenden pn-Gebiet vorhandenen Ladungsträger ist die Kippspannung der Hochspannungskippdiode heruntergesetzt und die Hochspannung wird an die Zündkerze ZK1 durchgeschaltet. Die Hochspannungskippdiode 18 sperrt für die nun entgegengesetzt vorliegende Spannung. Durch das gezielte Ansteuern des Tyristors, der sich im Hochspannungszweig der als nächstes zu zündenden Zündkerze befindet, kann so eine genaue Auswahl der Zündkerze und damit die Verteilung der Hochspannung erfolgen. Der Ansteuerimpuls von der Steuereinheit 13 an das Gate des Tyristors 19 erfolgt ca. 100 µ-Sekunden vor dem Ende des positiven Einschaltimpulses, also vor Ende der Schließzeit. Damit wird sichergestellt, daß eine ausreichende Überflutung der Hochspannungskippdiode mit Ladungsträgern erfolgt. Der Vorgang der Ladungsträgerfreisetzung soll zur Verdeutlichung anhand der Figur 5, welche im Querschnitt den Aufbau eines einzelnen in Planartechnik hergestellten Kippdiodchips zeigt, erläutert werden. Die dargestellte Kippdiode ist eine Vierschichtdiode, welche aus dem Sperrzustand in den Durchlaßzustand kippt, wenn die Spannung zwischen Anode und Katode einen bestimmten Wert überschreitet. Der einzelne Kippdiodenchip 30 besteht aus einem ca. 100 bis 600 µm dicken monokristallinen Halbleiter, insbesonder aus Silizium, in welchem die einzelnen Schichten (p, n, p, n) durch Diffussion von Dotierungen eingebracht sind. Auf der Kippdiodenchipunterseite 31 ist eine Anodenmetallisierung 32 aufgebracht, um so den elektrischen Anschluß herstellen zu können. An der Kippdiodenchipoberseite 33 ist die Katodenmetallisierung 34 aufgebracht. Der hochsperrende pn-Übergang ist mit dem Bezugszeichen 35 versehen. Wird nun während des Spulenladevorganges der Tyristor 19 angesteuert, so treten aus der p-Schicht 36 Ladungsträger in die n-Schicht 37 aus. Die Ladungsträger sind in Figur 5 symbolisch dargestellt und mit dem Bezugszeichen 38 versehen. Diese Ladungsträger 38 sorgen dafür, daß nach dem Abschalten des Zündspulenladestromes und der dadurch nun negativen sekundärseitigen Hochspannung die Kippspannung herabgesetzt ist. Es ist keine weitere Ansteuerung für die Hochspannungskippdiode beispielsweise mittels Licht notwendig.

Auf Figur 1 zurückkommend ist auszuführen, daß der erste Teil 15 und der zweite Teil 16 der Hochspannungskippdiode HKD sich darin unterscheiden, daß ein Teil der Kippdiodenchips eine lange Ladungsträgerspeicherzeit aufweist, während der andere Teil aus Kippdiodenchips mit einer kurzen Ladungsträgerspeicherzeit besteht. Damit bleiben die Ladungsträger 38 nur in dem Teil mit langer Ladungsträgerspeicherzeit lange genug erhalten, um eine Herabsetzung der Kippspannung zu bewirken. Der ander Teil hat damit weiterhin die Funktion einer Kippdiode, die bei erreichen einer vorgebbaren Spannung nämlich der Kippspannung schlagartig vom sperrenden in den leitenden Zustand übergeht und so einen Aufsteilerungsseffekt an der Zündkerze bewirkt.

Figur 2 zeigt ein zweites Ausführungsbeispiel, welches im wesentlichen dem Ausführungsbeispiel nach Figur 1 entspricht, weshalb gleiche Teile mit gleichen Bezugszeichen versehen sind und nicht nochmals erläutert werden sollen. Der einzige Unterschied der Figur 2 gegenüber der Figur 1 besteht darin, daß die Einschaltfunkenunterdrückungsdiode 17 weggelassen wurde. Die Funktion der Diode 17 übernimmt hier der zweite Teil 16 der Hochspannungskippdiode HKD. Während des Ansteuerimpulses an den Tyristor 19 fließt ein Konditionierungsstrom durch den ersten Teil 15 der Hochspannungskippdiode, welcher eine lange Ladungsträgerspeicherzeit hat. Der zweite Teil 16 sorgt ebenso wie in der Figur 1 die Diode 17 dafür, daß während des Zündspulenladevorgangs und des Ansteuerimpulses an den Tyristor 19 kein Strom über eventuell vorhandene Nebenschlüsse an der Zündkerze ZK1 abfließt. Der zweite Teil 16 der Hochspannungskippdiode HKD ist so designed, daß er in Rückwärtsrichtung einige Kilovolt sperren kann.

Ein drittes Ausführungsbeispiel ist in Figur 3 dargestellt. Auch hier wurden für gleiche Bauteile gleiche Bezugszeichen verwendet und deren Funktion nicht nochmals näher erläutert. Lediglich der Hochspannungszweig der Sekundärspule 14 zur Zündkerze unterscheidet sich in seiner Ausgestaltung von dem Ausführungsbeispiel nach Figur 1 und 2. So ist der Hochspannungsanschluß der Sekundärspule 14 über die Diode 40 und die rückwärts leitende Hochspannungskippdiode HKD, die wiederum aus einem ersten Teil 41 und einem zweiten Teil 42 besteht, mit der Zündkerz ZK1 und parallel zur Zündkerze ZK1 mit einem Kondensator 43 verbunden. Die Zündkerze ZK1 und der Kondensator sind ferner mit Masse verbunden. Die Photodiode 40 übernimmt die Funktion einer Einschaltfunkenunterdrückungsdiode. Dieser Photodiode 40 ist außerdem eine Leuchtdiode 44 so zugeordnet, daß die Sperrspannung der Diode 40 durch Bestrahlung mit Licht herabsetzbar ist. Die Leuchtdiode 44 wird von der Steuereinheit 13 angesteuert, wobei hier wiederum analog zum Thyristor die Diode 40 unmittelbar vor Ende des Zündspulenladevorgangs kurzzeitig aufgesteuert wird. Während des Ansteuerns der LED 44 und damit der Diode 40 fließt durch die Hochspannungskippdiode ein Konditionierungsstrom in Rückwärtsrichtung in den Kondensator und zwar solange bis der Kondensator aufgeladen ist, wobei wiederum Ladungsträger 38 freigesetzt werden, die nach dem Abschalten des Zündtransistors am Ende der Schließzeit für eine Herabsetzung der Kippspannung sorgen.

## Patentansprüche

1. Zündanlage für Brennkraftmaschinen mit mindestens einer aus Primärwicklung (10) und Sekundärwicklung (14) bestehenden Zündspule (11), wobei in Reihe mit der Primärwicklung (10) ein steuerbarer Schalter (12) angeordnet ist, welcher von einer Steuereinheit (13) ansteuerbar ist, wobei in jedem sekundärseitigen Zündzweig zwischen dem hochspannungsseitigen Ende der Sekundärwicklung (14) und einer Zündkerze (ZK1, ZK2, ... ZKn) mindestens eine Hochspannungskippdiode (HKD) angeordnet ist, die aus einer Vielzahl von in Reihe geschalteten und in Planartechnik hergestellten Kippdiodenchips besteht, und mit einer steuerbaren Schalteinheit (19, 40), die mit der Hochspannungskippdiode (HKD) in Reihe liegt und die von der Steuereinheit (13) während des Zündspulenladevorganges ansteuerbar ist, so daß durch die Hochspannungskippdiode (HKD) ein, durch den positiven Zündspulenladestrom verursachter, Konditionierungsstrom in Rückwärtsrichtung fließt, der in der Hochspannungskippdiode den sperrenden Bereich mit Ladungsträgern (38) überschwemmt.

2. Zündanlage nach Anspruch 1, dadurch gekennzeichnet, daß die steuerbare Schalteinheit parallel zur Zündkerze liegt und aus einer Reihenschaltung, einer Hochspannungsdiode und einem Thyristor besteht.

3. Zündanlage nach Anspruch 2, dadurch gekennzeichnet, daß der Gate-Anschluß des Tyristors mit der Steuereinheit (13) verbunden ist.

4. Zündanlage nach Anspruch 1, dadurch gekennzeichnet, daß die Hochspannungskippdiode (HKD) aus einem ersten und einem zweiten Teil besteht, wobei ein Teil aus Kippdiodenchips mit langer Ladungsträgerspeicherzeit und der andere Teil aus Kippdiodenchips mit kurzer Ladungsträgerspeicherzeit besteht.

5. Zündanlage nach Anspruch 1, dadurch gekennzeichnet, daß in Reihe mit der Hochspannungskippdiode eine Diode geschaltet ist, die über eine optoelektronische Wirkverbindung ansteuerbar ist.

6. Zündanlage nach Anspruch 5, dadurch gekennzeichnet, daß der Diode eine Leuchtdiode, die mit der Steuereinheit verbunden ist, zugeordnet ist.

## Claims

1. Ignition system for internal combustion engines, having at least one ignition coil (11) comprising primary winding (10) and secondary winding (14), a controllable switch (12), which can be actuated by a control unit (13), being connected in series with the primary winding (10), at least one high-voltage break-over diode (HKD), which comprises a plurality of brake-over diode chips connected in series and manufactured using planar technology, being arranged in each secondary-side ignition branch between the high-voltage-side end of the secondary winding (14) and a spark plug (ZK1, ZK2,...ZKn), and having a controllable switching unit (19, 40), which is connected in series with the high-voltage break-over diode (HKD) and which can be actuated by the control unit (13) during the ignition coil-charging process, with the result that a conditioning current, caused by the positive ignition coil-charging current, flows through the high-voltage break-over diode (HKD) in the reverse direction and floods the reverse-biased region in the high-voltage break-over diode with charger carriers (38).

2. Ignition system according to Claim 1, characterized in that the controllable switching unit is located parallel to the spark plug and comprises a series circuit, a high-voltage diode and a thyristor.

3. Ignition system according to Claim 2, characterized in that the gate terminal of the thyristor is connected to the control unit (13).

4. Ignition system according to Claim 1, characterized in that the high-voltage break-over diode (HKD) comprises a first and second part, one part comprising break-over diode chips with long charger carrier storage time and the other part comprising break-over diode chips with a short charge carrier storage time.

5. Ignition system according to Claim 1, characterized in that a diode, which can be actuated via an optoelectronic operative connection, is connected in series with the high-voltage break-over diode.

6. Ignition system according to Claim 5, characterized in that the diode is assigned a light-emitting diode, which is connected to the control unit.

## Revendications

1. Système d'allumage pour des moteurs à combustion interne comprenant au moins une bobine d'allumage (11), qui se compose d'un enroulement primaire (10) et d'un enroulement secondaire (14), un interrupteur (12), que l'on peut commander, étant disposé en série avec l'enroulement primaire (10), interrupteur (12) qui peut être commandé par une unité de commande (13), une diode à bascule à haute tension(HKD) étant disposée dans chaque branche d'allumage située du côté secondaire entre l'extrémité, située du côté haute tension, de l'enroulement secondaire (14) et une bougie d'allumage (ZK1, ZK2 ... ZKn), diode à bascule à haute tension(HKD) qui se compose d'un certain nombre de puces de diode à bascule montées en série et fabriquées selon la technique planaire, le système d'allumage comprenant encore une unité de branchement qui peut être commandée (19, 40), qui se trouve en série avec la diode à bascule à haute tension(HKD) et qui peut être commandée par l'unité de commande (13) pendant le processus de charge de la bobine d'allumage, de telle sorte qu'un courant de conditionnement, causé par le courant positif de charge de la bobine d'allumage, passe à travers la diode à bascule à haute tension(HKD) en marche arrière, courant qui submerge dans la diode à bascule à haute tension la zone de blocage avec des porteurs de charge (38).

2. Système d'allumage selon la revendication 1,
caractérisé en ce que
l'unité de branchement qui peut être commandée se trouve en parallèle avec la bougie d'allumage et de compose d'un circuit en série, composé d'une diode haute tension et d'un thyristor.

3. Système d'allumage selon la revendication 2,
caractérisé en ce que
le raccord de la grille du thyristor est relié à l'unité de commande (13).

4. Système d'allumage selon la revendication 1,
caractérisé en ce que
la diode à bascule à haute tension(HKD) se compose d'une première partie et d'une seconde partie, l'une des parties consistant en des puces de diode à bascule avec un long temps d'accumulation de porteurs de charge et l'autre partie en des puces de diode à bascule avec un court temps d'accumulation de porteurs de charge.

5. Système d'allumage selon la revendication 1,
caractérisé en ce que
on monte en série avec la diode à bascule à haute tension une diode, qui peut être commandée au moyen d'une liaison opérationnelle optoélectronique.

6. Système d'allumage selon la revendication 5,
caractérisé en ce que
l'on associe à la diode une diode luminescente, qui est reliée à l'unité de commande.
